Europäisches Patentamt

European Patent Office

Office européen des brevets

(11) Veröffentlichungsnummer: **0 380 740**
**A2**

## EUROPÄISCHE PATENTANMELDUNG

(21) Anmeldenummer: 89112015.6

(22) Anmeldetag: 01.07.89

(51) Int. Cl.⁵: **H05K 9/00, H01R 23/68,**
**H05K 7/20**

(30) Priorität: 03.02.89 DE 3902322

(43) Veröffentlichungstag der Anmeldung:
**08.08.90 Patentblatt 90/32**

(84) Benannte Vertragsstaaten:
**DE ES FR GB IT NL SE**

(71) Anmelder: **VDO Adolf Schindling AG**
**Gräfstrasse 103**
**D-6000 Frankfurt/Main 90(DE)**

(72) Erfinder: **Barz, Herbert**
**Faulbrunnenweg 5**
**D-6093 Flörsheim/Main 4(DE)**
Erfinder: **Langner, Frank**
**Im Dorfband 32**
**D-6090 Rüsselsheim(DE)**

(74) Vertreter: **Klein, Thomas, Dipl.-Ing. (FH)**
**Sodener Strasse 9 Postfach 6140**
**D-6231 Schwalbach a. Ts.(DE)**

(54) Elektronischer Schaltkreis.

(57) Es wird ein elektronischer Schaltkreis für ein Kraftfahrzeug, insbesondere in einem Kombinationsinstrument, angegeben. Der elektronische Schaltkreis umfaßt eine Rechnereinheit mit wenigstens einem Mikrorechner und anwendungsspezifischen integrierten Schaltkreisen und ist zur Dämpfung elektromagnetischer Störungen in einem Schirmungsgehäuse angeordnet. Zur verbesserten Wärmeabfuhr und Hf-Entkopplung sind Flächenbereiche der äußeren Abschirmung mit entsprechenden Flächenbereichen auf der Leiterbahn elektrisch und mechanisch eng gekoppelt und darüber hinaus die störgefährdeten ein- und ausgehenden Leitungen durch geeignete Filtermaßnahmen geschützt.

Fig. 1

EP 0 380 740 A2

Die Erfindung bezieht sich auf einen elektronischen Schaltkreis in einem Kraftfahrzeug, insbesondere in einem Kombinationsinstrument, bei dem verschiedene Anzeigeinstrumente, Anzeigefelder, Kontroll- und Warnleuchten und ggfs. Bedienteile sowie elektrische und elektronische Ausrüstungsteile in einem gemeinsamen Gehäuse angeordnet und durch eine gemeinsame Sichtscheibe abgedeckt sind. Derartige Kombinationsinstrumente sind seit langem bekannt, beispielsweise aus der DE-AS 16 05 947, und werden anstelle der früher üblichen Einzelinstrumente zur Kontrolle verschiedener Funktionen eines Kraftfahrzeugs eingesetzt.

In zunehmendem Maße werden elektrisch gesteuerte Anzeigen in solchen Kombinationsinstrumenten verwendet, die neben der größeren Gestaltungsfreiheit eine intelligentere Ansteuerung und damit genauere oder sinnfälligere Anzeigen ermöglichen. Die Ansteuerung erfolgt im allgemeinen unter Verwendung von Mikroprozessoren oder hochintegrierten, anwendungsspezifischen Schaltkreisen. Die darin verarbeiteten digitalen Impulsfolgen sind sehr steilflankig und beinhalten Hochfrequenzanteile bis in den Ultrakurzwellenbereich, infolgedessen sind sie Ursache für Funkstörungen, die beim Betrieb des Kraftfahrzeuges den Rundfunkempfang oder Funkverkehr erschweren. Außerdem sind diese Schaltkreise von außen durch Hf-Einstrahlung beeinflußbar.

Es ist bereits vorgeschlagen worden (Patentanmeldung P 37 36 761.7), einen Anzeigerechner vorzusehen und diesen in einem hochfrequenzdichten Gehäuse auf der gemeinsamen Leiterplatte anzuordnen.

Der Erfindung liegt demgemäß die Aufgabe zugrunde, einen elektronischen Schaltkreis nach dem Gattungsbegriff so weiterzubilden, daß sowohl die Auswirkungen leitungsgebundener und nichtleitungsgebundener Störungen bekämpft als auch die drahtlose Ausbreitung ausgehender radiofrequenter Funkstörungen vermindert werden.

Es ist zwar aus der DE-OS 35 15 910 ein hochfrequenzdichtes Gehäuse mit Anschlußstutzen bekannt, das der Abschirmung hochfrequenztechnischer Anlageteile dient, dabei handelt es sich jedoch um einen Abzweiger oder Verteiler für Kabelfernsehanlagen mit einem Netz aus Koaxialkabeln.

Ferner soll bei einem elektronischer Schaltkreis der eingangs genannten Art die erforderliche Einbautiefe möglichst gering gehalten, die baulichen Abmessungen klein und die Montage vereinfacht werden. Dabei soll die elektromagnetische Verträglichkeit verbessert und die auftretende Verlustwärme gut an die Umgebung abgeführt werden. Gleichzeitig soll die Betriebssicherheit erhöht, insbesondere wegen der engen Anordnung der wärmeerzeugenden Bauteile die Wärmeabfuhr verbessert werden. Schließlich soll der elektronische Schaltkreis, und damit das Kombinationsinstrument insgesamt, einfach und preisgünstig herzustellen sein.

Die Lösung dieser Aufgabe erfolgt mit den im kennzeichnenden Teil des Hauptanspruchs angegebenen Maßnahmen. Dabei ist vorteilhaft, daß sich die erfindungsgemäßen Maßnahmen nur auf einen Teil des Kombinationsinstruments erstrecken und daher wenig kostenaufwendig sind. Weiter ist vorteilhaft, daß der bisherige Aufbau eines Kombinationsinstruments nicht grundsätzlich geändert werden muß. Ferner ist vorteilhaft, daß die elektromagnetische Verträglichkeit verbessert ist. Schließlich ist vorteilhaft, daß die auftretende Verlustwärme gut an die Umgebung abführbar ist.

Vorteilhafte Ausgestaltungen und Weiterbildungen des erfindungsgemäßen elektronischen Schaltkreises ergeben sich aus den Unteransprüchen.

Ausführungsbeispiele der Erfindung sind in der Zeichnung dargestellt und in der nachfolgenden Beschreibung näher erläutert.

Es zeigen:

Figur 1 beispielhaft ein den elektronischen Schaltkreis enthaltendes Kombinationsinstrument in Frontansicht,

Figur 2 das gleiche Kombinationsinstrument in auseinandergezogener, perspektivischer Darstellung ohne Frontblende,

Figur 3 ein erstes Ausführungsbeispiel eines erfindungsgemäßen elektronischen Schaltkreises in auseinandergezogener, perspektivischer Darstellung,

Figur 4 der elektronische Schaltkreis aus Figur 3 in zusammengebautem Zustand in teilweise geschnittener Draufsicht und im Querschnitt

Figur 5 Einzelheiten des Ausführungsbeispiels nach den Figuren 3 und 4,

Figur 6 ein zweites Ausführungsbeispiel des elektronischen Schaltkreises in Schnittdarstellung.

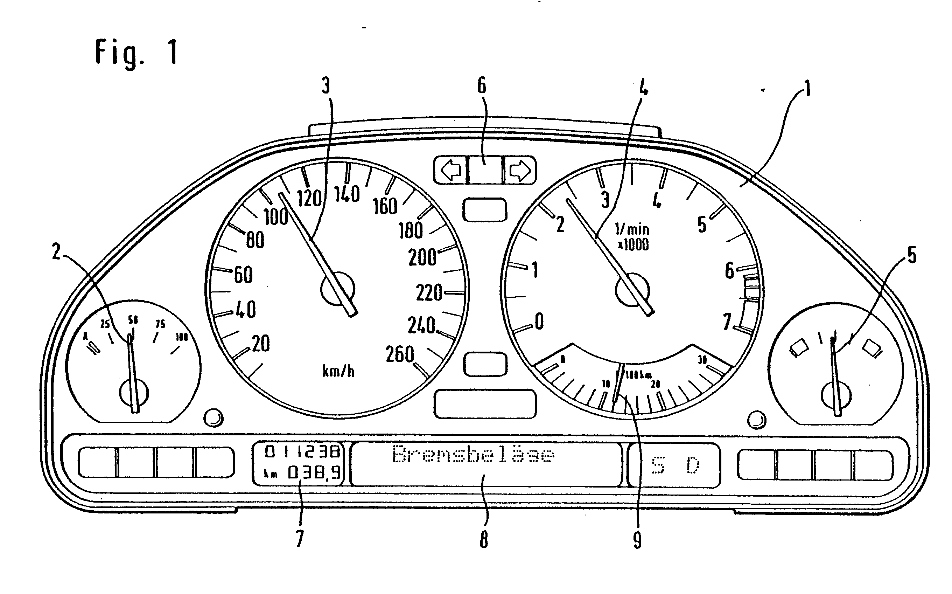

In Figur 1 ist mit 1 die Frontblende eines Kombinationsinstruments bezeichnet, das nebeneinander in wesentlich der gleichen Ebene eine Tankvorratsanzeige 2, einem Geschwindigkeitsmesser 3, einen Motordrehzahlmesser 4 mit integrierter Verbrauchsanzeige 9 und eine Kühlwasseranzeige 5 aufweist, ferner eine Kontrolleuchte 6 für den Fahrtrichtungsanzeiger sowie eine Flüssigkristallanzeige 7 für den elektronischen Wegstreckenanzeiger und eine Punktmatrixanzeige 8 für verschiedene Wahlfunktionen.

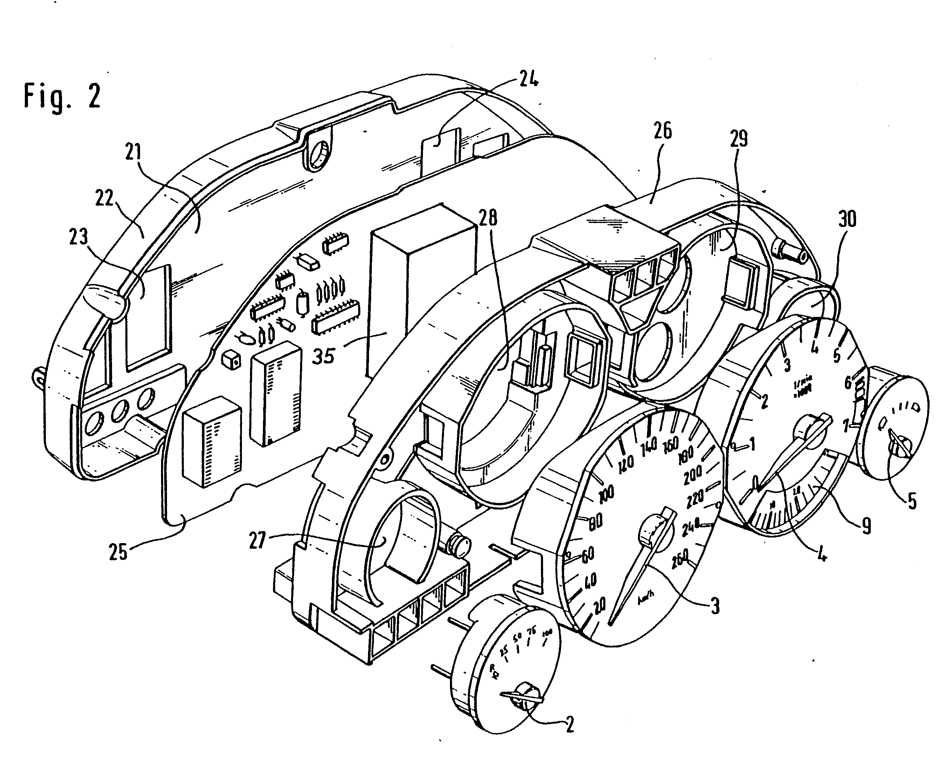

Figur 2 zeigt den Aufbau des Kombinationsinstruments. Es besteht aus einer Rückwand 21 mit angeformtem Rand 22. In der Rückwand sind eine Anzahl von Durchbrüchen 23, 24 zur Aufnahme von Steckverbindungen vorgesehen, die zur elektrischen Verbindung des Kombinationsinstruments mit den zugehörigen Sensoren und Fremdschaltkreisen, wie z.B. dem Schaltkreis zur Aktivierung der Fahrtrichtungsanzeige, dienen.

In die Rückwand 21 ist eine Leiterplatte 25 einlegbar, die alle für die Funktion des Kombinationsinstruments erforderlichen aktiven und passiven Schaltelemente, Leiterbahnen, Steckverbinder und Anschlußpunkte enthält. Die Leiterplatte 25 trägt ferner die für die Signalverarbeitung erforderliche Rechnereinheit, die z.B. aus zwei Einzel-Chip-Mikrorechnern und anwendungsspezifischen integrierten Schaltkreisen bestehen kann. Diese Rechnereinheit ist in später noch zu beschreibenden Weise in einem Abschirmgehäuse 35, auf der Leiterplatte 25 angeordnet.

Vor der Leiterplatte 25 ist eine Trägerplatine 26 vorgesehen, die ebenso wie die Rückwand 21 aus einem thermoplastischen Kunststoff geeigneter Zusammensetzung im Spritzgießverfahren hergestellt sein kann. Sie bestimmt zusammen mit dem Rand 22 der Rückwand 21 die äußere Gestalt des Kombinationsinstruments und weist eine Anzahl von Durchbrüchen 27, 28, 29, 30 zur Aufnahme der elektromechanischen Anzeigesysteme für die Analoganzeigen 2 bis 5 und 9 auf. Diese Anzeigesysteme lassen sich als Komponenten des Kombinationsinstruments je nach Ausstattungsvariante des Fahrzeugs in bestimmtem Umfang austauschen und entsprechend mit der Leiterplatte 25 verbinden. So kann anstelle des Motordrehzahlmessers 4 mit integrierter Tankanzeige 9 eine Zeituhr eingebaut und betrieben werden. Ebenso lassen sich elektrooptische Displays für die angegebenen Anzeigefunktionen bei entsprechenden Gestaltung und Auslegung der verwendeten Komponenten des Kombinationsinstruments verwenden.

Wie bereits eingangs erwähnt, erfordert der Einsatz hochintegrierter Elektronik in einem Kombinationsinstrument für Kraftfahrzeuge besondere Maßnahmen zur Abschirmung und Störungsunterdrückung in beiden Richtungen. Dabei soll sowohl die übrige Fahrzeugelektronik, insbesondere das Rundfunkempfangsgerät, vor Störungen durch den Instrumentenrechner als auch die Rechnereinheit vor Störungen von außen geschützt werden. Außerdem soll die Einbautiefe nur um das unbedingt notwendige Maß vergrößert werden. Dazu wird im wesentlichen nur die Rechnereinheit mit einigen Peripherie-Bausteinen geschirmt.

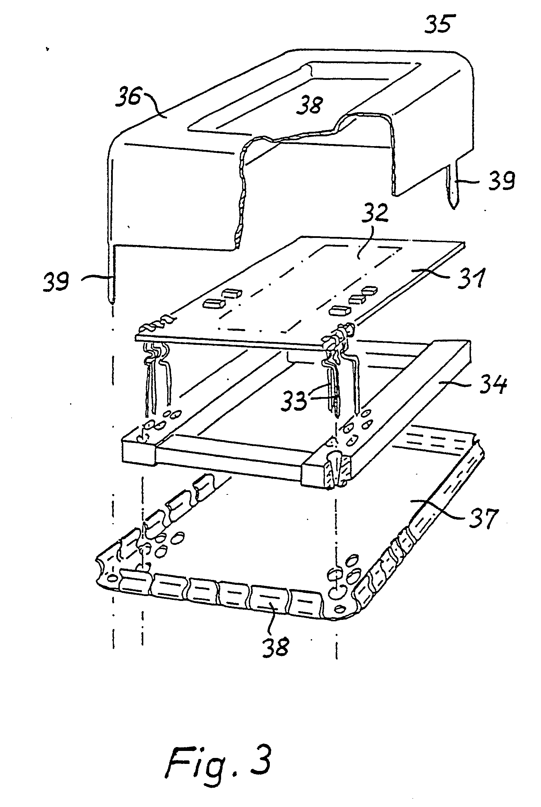

Gemäß einem ersten Ausführungsbeispiel der Erfindung ist daher auf der Leiterplatte 25 entsprechend den Figuren 3 bis 5 die Rechnereinheit in einem hochfrequenzdichten Gehäuse 35 angeordnet. Die Rechnereinheit ist dazu auf einem Keramiksubstrat 31 im Randbereich so untergebracht, daß ein Bereich 32 des Keramiksubstrats 31 von Schaltelementen frei bleibt. Kontaktfedern 33, die um den Rand des Keramiksubstrats 31 greifen, dort elektrisch gut leitend befestigt sind, wobei Löten ebenso möglich ist wie Kleben, und mit den Endflächen von darauf befindlichen Leiterbahnen verbunden sind, stellen die Verbindung zur übrigen Schaltung her. Die Kontaktfedern 33 liegen in zwei unterschiedlichen Ausführungsformen vor, die miteinander abwechseln, so daß diese durch einen Halterahmen 34 jeweils in zwei zueinander versetzten Reihen ragen, wobei der Abstand von jeweils 2 Kontaktfedern in jeder Reihe doppelt so groß ist wie der Leiterbahnabstand auf dem Keramiksubstrat 31.

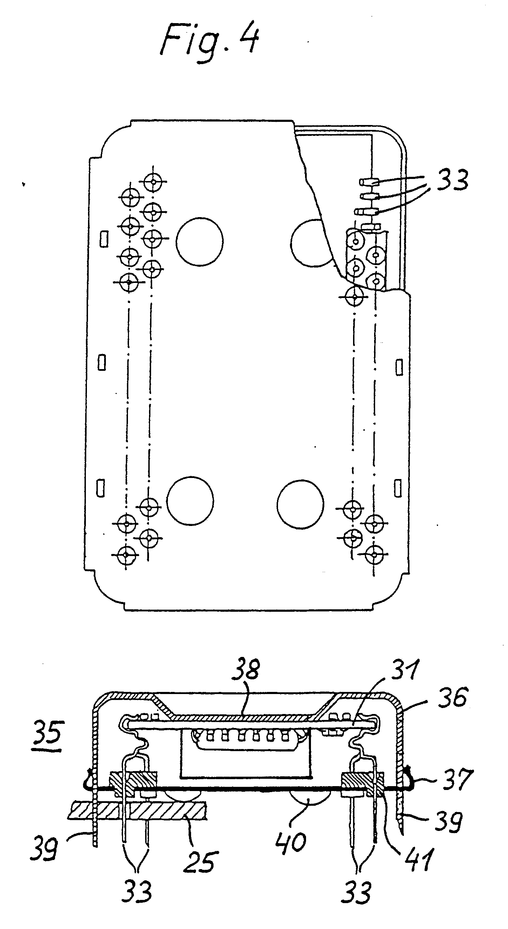

Die so komplettierte Rechnereinheit ist in einem Abschirmgehäuse 35 angeordnet, daß aus dem Abschirmbecher 36 und dem Deckel 37 besteht. Der Deckel 37 weist am Rand federnde Laschen 38 auf, die über den Rand des Abschirmbechers 36 greifen und diesen elektrisch leitend mit dem Deckel 37 verbinden. Zur Verbesserung der Hochfrequenz-Schirmwirkung können die federnden Laschen 38 mit dem Abschirmbecher 36 verlötet sein. Die Freifläche 32 des Keramiksubstrats 31 stellt eine Massefläche dar, die zweckmäßigerweise vor der Montage mit einem elektrisch gut leitenden und gut wärmeleitenden Kleber bestrichen wird und nach dem Zusammenbau an der Fläche 38 der wannenartigen Vertiefung am Boden des Abschirmbechers 36 anliegt. Dadurch wird sowohl die elektrische Abschirmwirkung als auch die Abfuhr der Verlustwärme verbessert.Da keine Stromschleifen der durch die Abblockkondensatoren fließenden Ströme gebildet werden, wird die Ausbildung elektromagnetischer Felder mit Abstrahlwirkung an der Außenseite vermieden. Zweckmäßigerweise weist der Abschirmbecher 36 an mehreren Stellen des Umfangs und in Verlängerung der Seitenwände Fortsätze 39 auf, die durch den Deckel 37 ragen und zur elektrischen Verbindung an die Bezugs-Masse-Leitung (z.B. Minuspol) auf der Leiterplatte 25 dienen, indem sie nach dem Durchstecken umgebogen werden unter Einstellung eines vorbestimmten Abstandes. In Figur 4 ist zu sehen, daß ein gewünschter Abstand des Deckels 37 der Abschirmeinrichtung 35 von der Leiterplatte 25 durch Abstandswarzen 40 eingestellt wird. Der Halterahmen 34 bildet auf der Unterseite jeweils zentrisch zu jeder Kontaktfeder 33 einen Zapfen 41 zur Isolierung der Kontaktfedern 33 gegenüber dem Deckel 37.

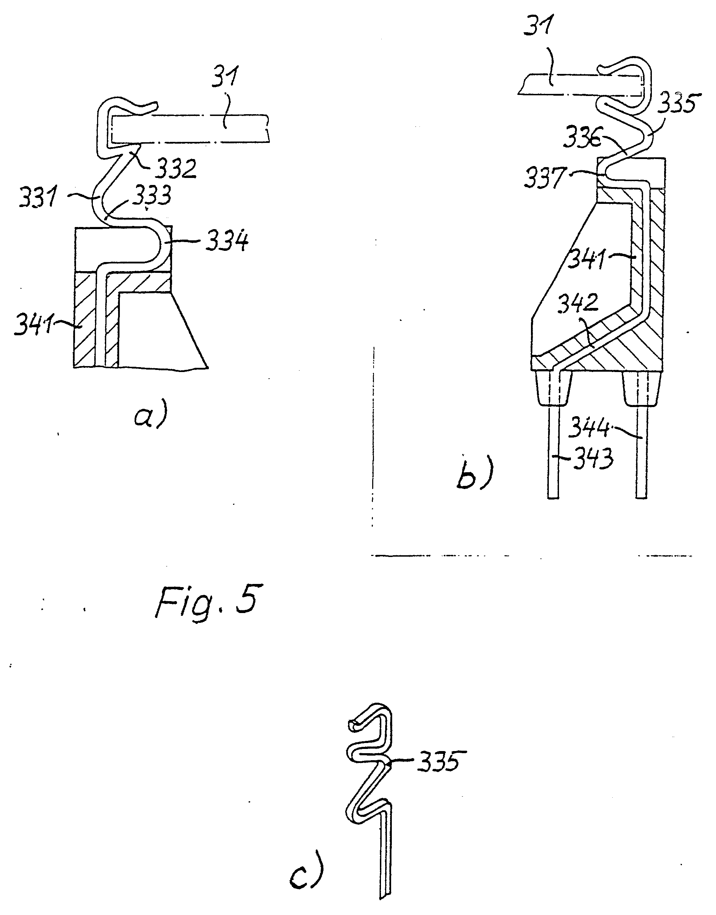

In Figur 5 sind verschiedene Ausführungsformen der Kontaktfedern dargestellt. Die Kontaktfeder 331 nach Figur 5a umfaßt U-förmig den Randbereich des Keramiksubstrats 31. Dabei bewirkt ein scharfkantiger Vorsprung 332 an der Unterseite einen großen Selbstreinigungseffekt und damit eine gute Kontaktverbindung zu der auf dem Keramiksubstrat 31 angeordneten Leiterbahn. Der Abstand zwischen dem Keramiksubstrat 31 und einem anstelle des Kunststofframens 34 vorgesehenen Kontaktgehäuses 341 wird durch die Kontaktfeder 331 in verschiedenen Bögen 331 und 334 überbrückt. Auf diese Weise können Wärmedehnungen weich aufgefangen und Überbeanspruchungen durch Rißbildung vermieden werden.

In ähnlicher Weise umfaßt die Kontaktfeder 335 das Keramiksubstrat 31, wobei die Kontaktfeder etwa die Form des großen griechischen Buchstabens Omega aufweist. Daran schließen sich zwei Bögen 336, 337 an, die wieder dem Abbau von Wärmespannungen dienen. Anschließend ist die Kontaktfeder 335 an der Stelle 338 rechtwinklig umgelenkt und in den Kunststoffhalter 341 eingebettet. Wie bereits oben erwähnt, sind zweckmäßigerweise zwei Arten von Kontaktfedern abwechselnd bestückt, wovon die eine ein Überleitungsstück 342 aufweist, das den Übergang zur benachbarten Kontaktreihe bewirkt. Auf diese Weise können zueinander versetzt wesentlich mehr Kontakte untergebracht und anschließend kontaktiert werden als dies bei einer nur einreihigen Anordnung der freien Enden 343, 344 der Kontaktfedern der Fall wäre. Die Kontaktfeder 335 ist in Figur 5c nochmals losgelöst von den umgebenden Bauteilen dargestellt. Dabei ist sichtbar, daß die Kontaktfeder 335 auf einfache Weise aus einem Halbzeug aus einem geeigneten Werkstoff, beispielsweise aus Kupfer-Beryllium-Draht herstellbar ist.

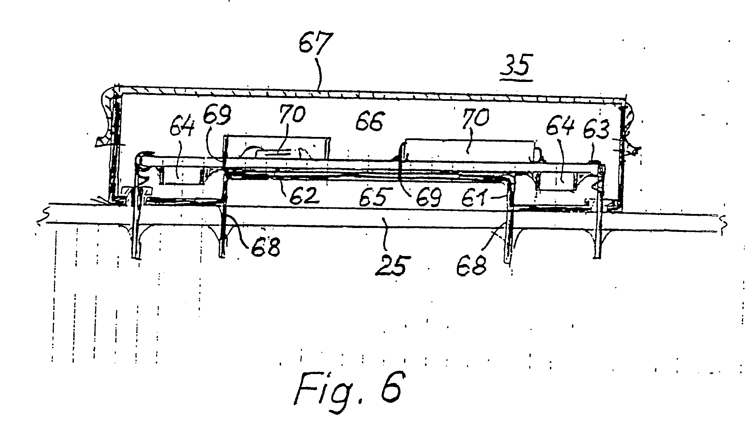

Bei dem in der Fig. 6 dargestellten Ausführungsbeispiel ist anstelle des Deckels des Abschirmgehäuses dessen Boden 61 eingezogen. Wie aus der Schnittdarstellung ersichtlich, wird dadurch eine von der Leiterplatte 25 entfernt liegende Fläche 62 gebildet, an welche das Keramiksubstrat 63 der Rechnereinheit unter großflächiger Berührung anschließt. Die dem Boden zugewandte Seite des Keramiksubstrats 63 ist in dem Bereich, in dem es die Fläche 62 berührt, von Bauteilen freigehalten, während im Randbereich des Keramiksubstrats 63 zahlreich Abblockkondensatoren 64 angeordnet sind. Die auf der Oberseite des Keramiksubstrats 63 angeordneten integrierten Schaltkreise 70 erhalten ihre Massezuführungen über Durchkontaktierungen 69. Hierdurch werden störende Stromschleifen vermieden.

Zur Verbesserung der elektrischen Leitung und/oder des Wärmeübergangs von dem Keramiksubstrat 63 zur Fläche 62 ist die Leiterplatte etwa kongruent zur Fläche 62 mit einer Massefläche versehen. Diese stellt dann gleichzeitig den Masse-Sternpunkt dar. Wie auch schon in dem weiter oben beschriebenen ersten Ausführungsbeispiel kann die Berührung der Flächen unter Zwischenlage einer Schicht eines elektrisch gut leitenden und/oder die Wärme gut leitenden Klebers erfolgen.

Die Bauart des Abschirmgehäuses nach Fig. 6 hat den großen Vorteil, daß der freie Raum 65 auf der Leiterplatte 25 des Kombinationsinstruments unterhalb der angehobenen Fläche 62 für die Anordnung weiterer Bauteile nutzbar ist. Außerdem läßt sich die fertige Rechnereinheit zum Schutz gegen äußere Einflüsse und Beschleunigungen in einfacher Weise ausgießen. Dabei wird der Raum 66 mit Vergußmasse gefüllt. Danach läßt sich mit dem Deckel 67 ohne Behinderung das Abschirmgehäuse 35 verschließen.

In besonders einfacher Weise läßt sich darüber hinaus die mechanische Befestigung und die Masseverbindung des Abschirmgehäuses 35 mit der Leiterplatte 25 dadurch erreichen, daß aus dem Boden 61 einzelne Laschen 68 aufgebogen und mit der Leiterplatte 25 verlötet werden.

## Ansprüche

1. Elektronischer Schaltkreis in einem Kraftfahrzeug, insbesondere in einem Kombinationsinstrument, bei dem verschiedene Anzeigeinstrumente, Anzeigefelder, Kontroll- und Warnleuchten und ggfs. Bedienteile sowie elektrische und elektronische Ausrüstungsteile in einem gemeinsamen Gehäuse angeordnet und durch eine gemeinsame Sichtscheibe abgedeckt sind, mit wenigstens einem mit Bauelementen bestückten Keramiksubstrat in einem Schirmgehäuse, dadurch gekennzeichnet, daß auf dem Keramiksubstrat (31, 63) eine Teilfläche (32) von Bauelementen frei gehalten und mit einer im wesentlichen kongruenten, in einer Außenfläche des Abschirmgehäuses (35) vertieft angeordneten Fläche (48) in flächenhafte Berührung bringbar ist.

2. Elektronischer Schaltkreis nach Anspruch 1, dadurch gekennzeichnet, daß die flächenhafte Berührung unter Zwischenschaltung eines elektrisch gut leitenden Klebers erfolgt.

3. Elektronischer Schaltkreis nach Anspruch 1 oder 2, dadurch gekennzeichnet, daß die flächenhafte Berührung unter Zwischenschaltung eines die Wärme gut leitenden Klebers erfolgt.

4. Elektronischer Schaltkreis nach einem oder mehreren der vorhergehenden Ansprüche, dadurch gekennzeichnet, daß die Massezuführung zu den auf dem Keramiksubstrat (31,63) angeordneten hochintegrierten Schaltkreisen (70) über Durchkontaktierungen (69) erfolgt.

5. Elektronischer Schaltkreis nach einem der Ansprüche 1 bis 4, dadurch gekennzeichnet, daß zur Halterung und elektrischen Verbindung des Keramiksubstrats (31, 63) Kontaktfedern (33) vorgesehen sind, die mit ihrem Endbereich U-förmig oder Omega-förmig die Randkontaktierung des Substrats umfassen, auf ihrer freien Länge S-förmig gekrümmt und abwechselnd unterschiedlich so geformt sind, daß ihre leiterplattenseitigen Enden jeweils zwei zueinander parallele versetzte Reihen bilden.

6. Elektronischer Schaltkreis nach Anspruch 5, dadurch gekennzeichnet, daß die Kontaktfedern (33) in Leisten (41) aus einem Isolierstoff gehaltert sind.

7. Elektronischer Schaltkreis nach einem oder mehreren der vorhergehenden Ansprüche, dadurch gekennzeichnet, daß der Abschirmbecher an mehreren Stellen des Umfangs und in Verlängerung der Seitenwände Fortsätze (39, 68) aufweist, die durch den Deckel (37) und die Leiterplatte (25) des Kombinationsinstruments ragen und deren freie Ende auf der dem hochfrequenzdichten Gehäuse (35) abgewandten Seite der Leiterplatte (25) elektrische gut leitend mit einem Masse-Anschluß oder einer Masse-Fläche der umgebenden Schaltung verbunden sind.

8. Elektronischer Schaltkreis nach Anspruch 5, dadurch gekennzeichnet, daß der Deckel wenigstens drei nach außen weisende Prägungen (4) zur Bestimmung des Abstandes der Deckelfläche zur Leiterplatte (25) des Kombinationsinstruments aufweist.

9. Elektronischer Schaltkreis nach einem oder mehreren der vorhergehenden Ansprüche, dadurch gekennzeichnet, daß die vertieft angeordnete Fläche (38, 62) auf der der tragenden Leiterplatte (25) zugewandten Seite des Abschirmgehäuses (35) angeordnet ist.

Fig. 1

## Fig. 2

Fig. 3

*Fig.4*

Fig. 5

Fig. 6